# EUROPÄISCHE PATENTSCHRIFT

(11) **EP 2 619 844 B1**
(45) Veröffentlichungstag und Bekanntmachung des Hinweises auf die Patenterteilung: **11.03.2020**
(21) Anmeldenummer: 11749388.2
(22) Anmeldetag: 12.08.2011
(51) Int. Cl.: H01M 10/48, G01R 31/396, G01R 31/3835, H04Q 9/00, H01M 10/052

(54) **BATTERIESYSTEM UND VERFAHREN ZUR BESTIMMUNG VON BATTERIEMODULSPANNUNGEN**
BATTERY SYSTEM AND METHOD FOR DETERMINING BATTERY MODULE VOLTAGES
SYSTÈME DE BATTERIE ET PROCÉDÉ DE DÉTERMINATION DES TENSIONS DE MODULES DE BATTERIE

(30) Priorität: 20.09.2010 DE 102010041049
(43) Veröffentlichungstag der Anmeldung: 31.07.2013
(73) Patentinhaber: Robert Bosch GmbH, 70442 Stuttgart (DE); Samsung SDI Co., Ltd., Yongin-si Gyeonggi-do 446-577 (KR)
(72) Erfinder: BOSCH, Andreas, 71739 Oberriexingen (DE); FETZER, Joachim, 73342 Bad-Ditzenbach (DE); BUTZMANN, Stefan, 71717 Beilstein (DE); FINK, Holger, 70567 Stuttgart (DE); LANG, Martin, 74394 Hessigheim (DE)
(74) Vertreter: Bee, Joachim
(86) Internationale Anmeldenummer: PCT/EP2011/063940
(87) Internationale Veröffentlichungsnummer: WO 2012/038152

(56) Entgegenhaltungen:
- DE-A1-102008 043 921
- JP-A- 11 176 480
- US-A- 5 808 469
- US-A1- 2011 196 632

## Beschreibung

Die vorliegende Erfindung betrifft ein Batteriesystem, ein Verfahren zur Bestimmung von Batteriemodulspannungen des Batteriesystems und ein Kraftfahrzeug mit dem erfindungsgemäßen Batteriesystem.

### Stand der Technik

Es zeichnet sich ab, dass in Zukunft sowohl für stationäre Anwendungen, beispielsweise bei Windkraftanlagen, als auch in Fahrzeugen, beispielsweise in Hybrid- und Elektrofahrzeugen, vermehrt neue Batteriesysteme zum Einsatz kommen werden, an die sehr hohe Anforderungen bezüglich der Zuverlässigkeit gestellt werden.

Hintergrund für diese hohen Anforderungen ist, dass ein Ausfall des Batteriesystems zu einem Ausfall des Gesamtsystems führen kann. Beispielsweise hat bei einem Elektrofahrzeug ein Ausfall der Traktionsbatterie einen so genannten "Liegenbleiber" zur Folge. Außerdem kann der Ausfall einer Batterie zu einem sicherheitsrelevanten Problem führen. Bei Windkraftanlagen werden beispielsweise Batterien eingesetzt, um bei starkem Wind die Anlage durch eine Rotorblattverstellung vor unzulässigen Betriebszuständen zu schützen.

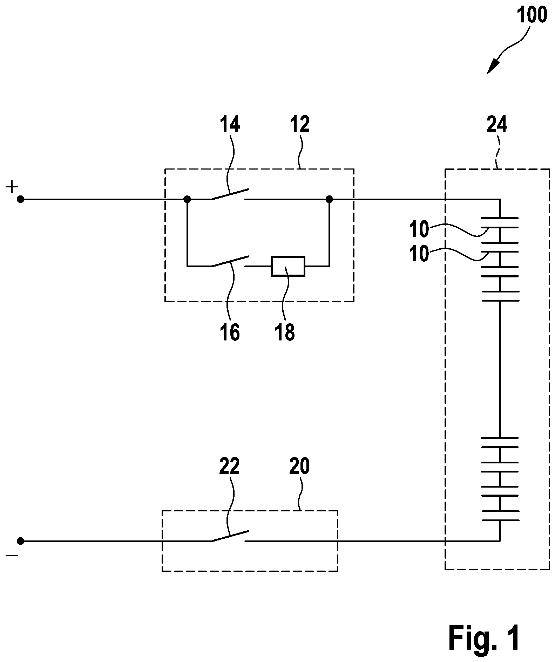

Das Prinzipschaltbild eines Batteriesystems gemäß dem Stand der Technik ist in Figur 1 dargestellt. Ein insgesamt mit 100 bezeichnetes Batteriesystem umfasst eine Vielzahl von Batteriezellen 10, die in mehreren Modulen 24 zusammengefasst sind. Ferner ist eine Lade- und Trenneinrichtung 12, welche einen Trennschalter 14, einen Ladeschalter 16 und einen Ladewiderstand 18 umfasst, vorgesehen. Zusätzlich kann das Batteriesystem 100 eine Trenneinrichtung 20 mit einem Trennschalter 22 umfassen.

Für den sicheren Betrieb des Batteriesystems 100 ist es zwingend notwendig, dass jede Batteriezelle 10 innerhalb eines erlaubten Betriebsbereichs (Spannungsbereich, Temperaturbereich, Stromgrenzen) betrieben wird. Liegt eine Batteriezelle 10 außerhalb dieser Grenzen, muss sie aus dem Zellverbund herausgenommen werden. Bei einer Serienschaltung der Batteriezellen 10 (wie in Figur 1 dargestellt) führt daher ein Ausfall einer einzelnen Batteriezelle 10 zum Ausfall des gesamten Batteriesystems 100.

Insbesondere in Hybrid- und Elektrofahrzeugen werden Batterien in Lithium-Ionen- oder Nickel-Metall-Hybrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewährleisten. So wird beispielsweise eine Zellspannungserfassungseinheit eingesetzt.

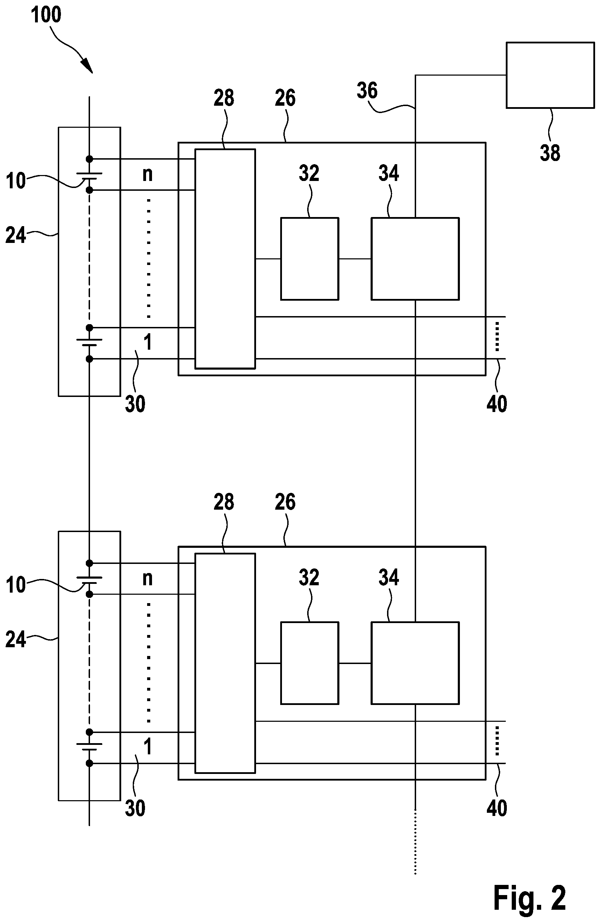

Figur 2 zeigt den bekannten Einsatz einer derartigen Zellspannungserfassungseinheit.

In Figur 2 ist eine aus dem Stand der Technik bekannte Architektur einer typischen Zellspannungserfassung gezeigt. Hierbei ist jedem Modul 24 mit seinen Batteriezellen 10 eine Zellspannungserfassungseinheit 26 zugeordnet. Die Zellspannungserfassungseinheit 26 umfasst einen Multiplexer 28, der über eine der Anzahl der Batteriezellen 10 entsprechende Anzahl von Kanälen 30 die Spannung jeder der einzelnen Batteriezellen 10 erfasst. Der Multiplexer 28 ist über einen Analog-Digital-Wandler 32 mit einem Gateway 34 verbunden, das an einen Kommunikationsbus 36 gekoppelt ist. An den Kommunikationsbus 36 ist ein zentrales Steuergerät, beispielsweise ein Mikrocontroller 38 angeschlossen. Über diesen Mikrocontroller 38 können somit die Spannungen der einzelnen Batteriezellen 10 erfasst und ausgewertet werden. Der Mikrocontroller 38 kann Bestandteil einer Batteriemanagementeinheit sein.

Wie Figur 2 verdeutlicht, können hier mehrere Module 24 mit Batteriezellen 10 in Serie angeordnet sein, die jeweils über eine eigene Zellspannungserfassungseinheit 26 verfügen.

Der Multiplexer 28 kann weiterhin Hilfseingänge 40 aufweisen, die bekanntermaßen für eine Temperaturmessung dienen können, indem beispielsweise eine Erfassung von Widerstandswerten von sogenannten Negative Temperature Coefficient-Widerständen (auch NTC-Widerständen) erfolgt.

Ein Nachteil der gezeigten Architektur besteht darin, dass das zentrale Steuergerät 38 lediglich mit der obersten Zellspannungserfassungseinheit 26 direkt kommuniziert und jede Zellspannungserfassungseinheit 26 mit der jeweils darunterliegenden. Damit sämtliche Zellspannungen an das zentrale Steuergerät 38 übertragen werden können, müssen sie durch alle weiter oben liegenden Zellspannungserfassungseinheiten 26 durchgereicht werden. Sofern mindestens eine der Zellspannungserfassungseinheiten 26 ausfällt, können die Zellspannungen aller darunterliegender Zellspannungserfassungseinheiten 26 nicht mehr vom zentralen Steuergerät 38 erfasst werden. Fällt im Extremfall die oberste Zellspannungserfassungseinheit 26 aus, kann keine einzige Zellspannung des Batteriesystems erfasst werden.

In US 5,808,469 A wird eine Batterieüberwachungseinrichtung offenbart, bei der jedes Batteriemodul einer Serienschaltung von Batteriemodulen jeweils über einen positiven Anschluss und einen negativen Anschluss mit einer zugehörigen positiven- bzw. negativen-Spannungsabnehmerleitung zum Erzeugen eines Batteriespannungssignals verbunden ist. Ferner weist die Batterieüberwachungseinrichtung eine Vielzahl von Schaltern auf, die über eine galvanische Trennung hinweg von einem Mikroprozessor angesteuert werden können, um basierend auf von dem Mikroprozessor empfangenen Addressierungseingaben ein bestimmtes Batteriespannungssignal auszulesen, das über die galvanische Trennung hinweg zu dem Mikroprozessor übertragen wird. Der Mikroprozessor kann ferner ausgelesene Batteriespannungssignale über einen Kommunikationsbus an andere Einheiten übertragen.

In JP11176480A wird eine Batteriesteuerungseinrichtung offenbart, bei die Batteriemodulspannung einer Vielzahl von in Reihe angeordneten Batteriemodulen mittels von einem Modulspannungsdetektionsschaltkreis detektiert wird, wobei jedes Batteriemodul separat an den Modulspannungsdetektionskreis angeschlossen ist. Zusätzlich wird die Gesamtspannung der Reihenschaltung aus Batteriemodulen mittels eines Gesamtspannungsdetektionsschaltkreises detektiert.

### Offenbarung der Erfindung

Erfindungsgemäß wird ein Batteriesystem mit mindestens zwei Modulen, die jeweils eine Vielzahl von Batteriezellen umfassen, zur Verfügung gestellt, wobei jedem Modul eine Zellspannungserfassungseinheit zugeordnet ist, und jede der Zellspannungserfassungseinheiten ausgebildet ist, die Spannung der einzelnen Batteriezellen des zugeordneten Moduls zu erfassen, und wobei die Zellspannungserfassungseinheiten über einen gemeinsamen Kommunikationsbus in Serie geschaltet und mit einem zentralen Steuergerät verbunden sind, wobei jedes Modul zusätzlich eine Modulspannungserfassungseinheit umfasst, die ausgebildet ist, die Spannung des zugeordneten Moduls separat zu erfassen.

Hierdurch wird vorteilhaft möglich, die über die Zellspannungserfassungseinheit gemessenen Zellspannungen zu verifizieren, indem die Spannungen der einzelnen Module zusätzlich separat gemessen und (gesondert) zum zentralen Steuergerät übertragen werden. Das zentrale Steuergerät wird somit in die Lage versetzt, die über die Zellspannungserfassungseinheiten ermittelten und über den Kommunikationsbus digitalisiert übertragenen Zellspannungen mit den zusätzlichen Informationen, die über die Modulspannungserfassungseinheiten bereitgestellt werden, zu vergleichen. Insbesondere kann so eine Plausibilität der über die Zellspannungserfassungseinheiten gelieferten Zellspannungsinformationen festgestellt beziehungsweise beurteilt werden. Fällt nun die Kette der Zellspannungserfassungseinheiten ganz oder teilweise aus, kann das Batteriesystem vorteilhafterweise für eine gewisse Zeit in einem noch näher zu beschreibenden Notlauf weiter betrieben werden.

In bevorzugter Ausgestaltung der Erfindung ist es vorgesehen, dass die Modulspannungserfassungseinheiten durch Modulmessleitungen ausgebildet sind, wobei jeweils eine erste Modulmessleitung mit einem Pluspol des zugeordneten Moduls und eine zweite Modulmessleitung mit einem Minuspol des zugeordneten Moduls verbunden und zum zentralen Steuergerät geführt sind. Diese Modulmessleitungen ermöglichen eine separate Messung der Modulspannungen unabhängig von der Betriebsbereitschaft der Zellspannungserfassungseinheiten beziehungsweise des gemeinsamen Kommunikationsbusses. Durch diese Ausgestaltung wird es in besonders einfacher Weise möglich, die jeweiligen Modulspannungen zu erfassen und diese aufbereitet dem zentralen Steuergerät zur Verfügung zu stellen.

Die Batteriezellen sind vorzugsweise als Lithium-Ionen-Batteriezellen ausgebildet. Ferner ist es in einer bevorzugten Ausgestaltung der Erfindung vorgesehen, dass jede Modulspannungserfassungseinheit einen analogen Optokoppler aufweist, der eingangsseitig mit den Modulmessleitungen und ausgangsseitig mit dem zentralen Steuergerät verbunden ist. Dies hat den Vorteil, dass die ausgangsseitigen Modulmessleitungen zum zentralen Steuergerät keine hohen Spannungen mehr führen, was zu einer Erhöhung der Systemsicherheit beiträgt.

Erfindungsgemäß wird ferner ein Verfahren gemäß Anspruch 5 zur Bestimmung von Batteriemodulspannungen des erfindungsgemäßen Batteriesystems vorgeschlagen, wobei jede der Zellspannungserfassungseinheiten die Spannungen der einzelnen Batteriezellen bestimmt und die bestimmten Spannungswerte über den gemeinsamen Kommunikationsbus zum zentralen Steuergerät übermittelt werden, wobei erfindungsgemäß zusätzlich für jedes Modul eine Modulspannung separat erfasst und dem zentralen Steuergerät zugeführt wird.
Hierdurch lassen sich in einfacher Weise die von den Zellspannungserfassungseinheiten bereitgestellten Informationen über die Spannungen der einzelnen Batteriezellen verifizieren und im Falle eines Ausfalls der Zellspannungserfassungseinheiten ist es vorteilhafterweise möglich, das Batteriesystem für eine gewisse Zeit in einem Notlauf weiter zu betreiben.
Dazu ist es in einer bevorzugten Ausführungsvariante des erfindungsgemäßen Verfahrens vorgesehen, dass im Falle eines Ausfalls mindestens einer Zellspannungserfassungseinheit, welcher durch Vergleich der vom gemeinsamen Kommunikationsbus übermittelten Spannungswerte mit vorgegebenen Referenzspannungswerten detektiert werden kann, die vom Batteriesystem bereitgestellte Stromstärke gemessen, und ausgehend vom (vorzugsweise zuletzt) bekannten Zustand der einzelnen Batteriezellen (vorzugsweise unmittelbar vor dem Ausfall) jeweils der Ladezustand und die Spannung der einzelnen Batteriezellen anhand des gemessenen Stroms abgeschätzt werden. Mit anderen Worten wird aus dem zuletzt bekannten Zustand der einzelnen Batteriezellen und dem zu diesem Zeitpunkt gemessenen Strom sowie dem danach kontinuierlich gemessenen Strom des Batteriesystems eine Abschätzung über die zeitliche Entwicklung von (Ladezustand und damit) den Zellspannungen der einzelnen Batteriezellen vorgenommen. Diese Abschätzung allein würde jedoch nicht ausreichen, um die hohen Anforderungen an die Zuverlässigkeit zu erfüllen und daher müsste das Batteriesystem ohne weitere, die Abschätzung verifizierende Informationen sofort abgeschaltet werden.
Da jedoch aus den geschätzten Spannungswerten der einzelnen Batteriezellen die Spannungen der einzelnen Module errechnet und diese mit den erfindungsgemäß separat erfassten Modulspannungen verglichen werden können, ist auch im Falle eines Ausfalls mindestens einer Zellspannungserfassungseinheit eine Aussage über die einzelnen Batteriezellen mit einer erhöhten Zuverlässigkeit möglich, da die separat erfassten Modulspannungen eine zusätzliche Information darstellen. Schließlich ist es vorgesehen, die Differenz der geschätzten Spannungswerte der Module mit den separat erfassten Modulspannungen zu berechnen und den Betrag dieser Differenz mit einem vorgegebenen Toleranzwert zu vergleichen. Wird der vorgegebene Toleranzwert unterschritten, ist ein Notbetrieb möglich, auch wenn keine Spannungswerte der einzelnen Batteriezellen, sondern lediglich Spannungswerte der Module vorliegen.

Vorzugsweise werden die genannten Verfahrensschritte im Falle eines Ausfalls mindestens einer Zellspannungserfassungseinheit ständig wiederholt, um einen Ausfall des Gesamtsystems zu vermeiden.

Bevorzugt ist dabei die Wiederholrate größer als 0,1 Hz. Nach einer Ausführungsform ist die Wiederholrate größer als 10 Hz.

Sofern der vorgegebene Toleranzwert erreicht oder überschritten wird, wird das Batteriesystem erfindungsgemäß abgeschaltet, da die Anforderungen an die Zuverlässigkeit nicht mehr sicher erfüllt werden können.

Ein weiterer Aspekt der Erfindung betrifft ein Kraftfahrzeug, welches das erfindungsgemäße Batteriesystem umfasst.

Insgesamt kann durch das erfindungsgemäße Batteriesystem beziehungsweise durch das erfindungsgemäße Verfahren erreicht werden, dass die Zuverlässigkeit des Batteriesystems überprüft werden kann und eventuelle Fehlfunktionen rechtzeitig erkannt werden, um Folgeschäden durch unzuverlässig arbeitende Batteriesysteme zu vermeiden.

Weiterhin ist selbst im Falle eines Ausfalls mindestens einer Zellspannungserfassungseinheit ein Weiterbetrieb des Batteriesystems für eine gewisse Zeit möglich.

### Zeichnungen

Ausführungsbeispiele der Erfindung werden anhand der Zeichnungen und der nachfolgenden Beschreibung näher erläutert. Es zeigen:
Figur 1 ein Batteriesystem nach dem Stand der Technik,
Figur 2 eine Architektur einer Zellspannungserfassungseinheit nach dem Stand der Technik,
Figur 3 ein erfindungsgemäßes Batteriesystem mit zusätzlicher Batteriemodulspannungsmessung gemäß einer ersten, bevorzugten Ausführungsvariante,
Figur 4 ein erfindungsgemäßes Batteriesystem mit zusätzlicher Batteriemodulspannungsmessung gemäß einer zweiten, bevorzugten Ausführungsvariante und
Figur 5 ein Blockschaltbild zur Bestimmung von Batteriemodulspannungen im erfindungsgemäßen Batteriesystem.

### Ausführungsformen der Erfindung

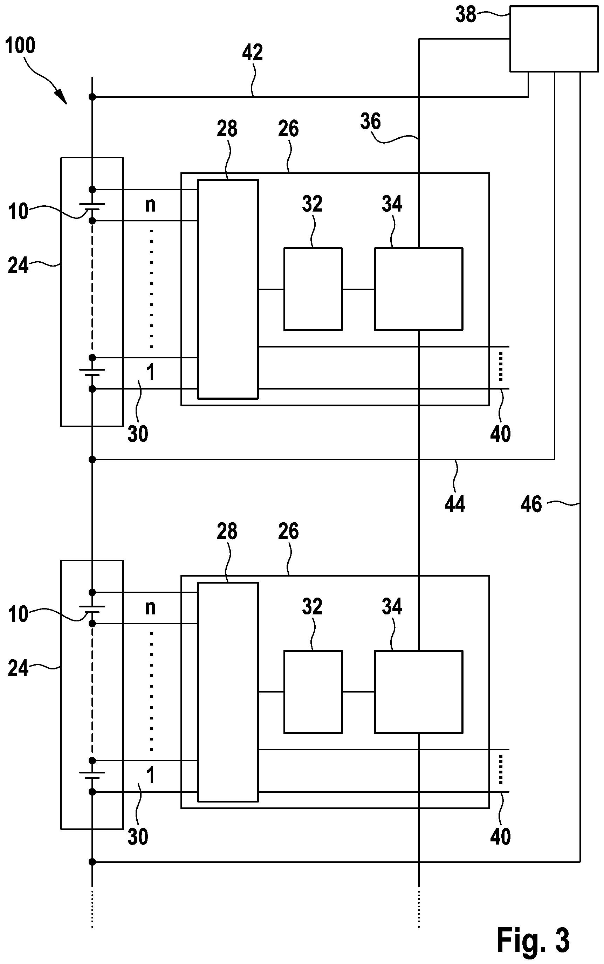

Figur 3 zeigt ein Batteriesystem 100 gemäß einer ersten bevorzugten Ausführungsvariante der Erfindung. Eine Vielzahl von Batteriezellen 10 ist in Reihe geschaltet und jeweils in Module 24 zusammengefasst. In einem Multiplexer 28 werden die Zellspannungen der einzelnen Batteriezellen 10 zusammengeführt und über einen Analog-Digital-Wandler 32 sowie ein Gateway 34 in einen gemeinsamen Kommunikationsbus 36 eingespeist. Über den Mikrocontroller 38 erfolgt die Spannungsauswertung in an sich bekannter Art und Weise.

In Figur 3 sind beispielhaft zwei Module 24 mit jeweils einer Vielzahl von Batteriezellen 10 dargestellt. Nach weiteren, nicht dargestellten Ausführungsbeispielen können auch mehrere der Module 24 in Reihe oder auch zusätzlich parallel zueinander verschaltet sein.

Jedem Modul 24 sind Modulmessleitungen 42, 44, 46 zugeordnet. Die Modulmessleitungen 42, 44, 46 greifen die über das jeweilige Modul 24 anliegende Spannung ab und führen diese zum zentralen Steuergerät, im vorliegenden Ausführungsbeispiel dem Mikrocontroller 38.

Das zentrale Steuergerät 38 erhält somit gleichzeitig sowohl die Information über die Spannungen der einzelnen Batteriezellen 10 (und damit auch als Summe dieser einzelnen Batteriezellspannungen 10 die Spannungen der Module 24) von den Zellspannungserfassungseinheiten 26 (über den Kommunikationsbus 36) als auch die separat über die Modulmessleitungen 42, 44, 46 abgegriffenen Modulspannungen.

Über eine entsprechende Zuordnung und einen Vergleich der Signale, die über den Kommunikationsbus 36 und die Modulmessleitungen 42, 44, 46 zur Verfügung gestellt werden, können ein Vergleich und eine entsprechende Auswertung stattfinden. Hierbei wird die jeweilige Modulspannung anhand der über die Modulmessleitungen 42, 44, 46 abgegriffenen Spannung bestimmt und mit den über die Zellspannungserfassungseinheiten 26 gemessenen Zellspannungen verglichen.

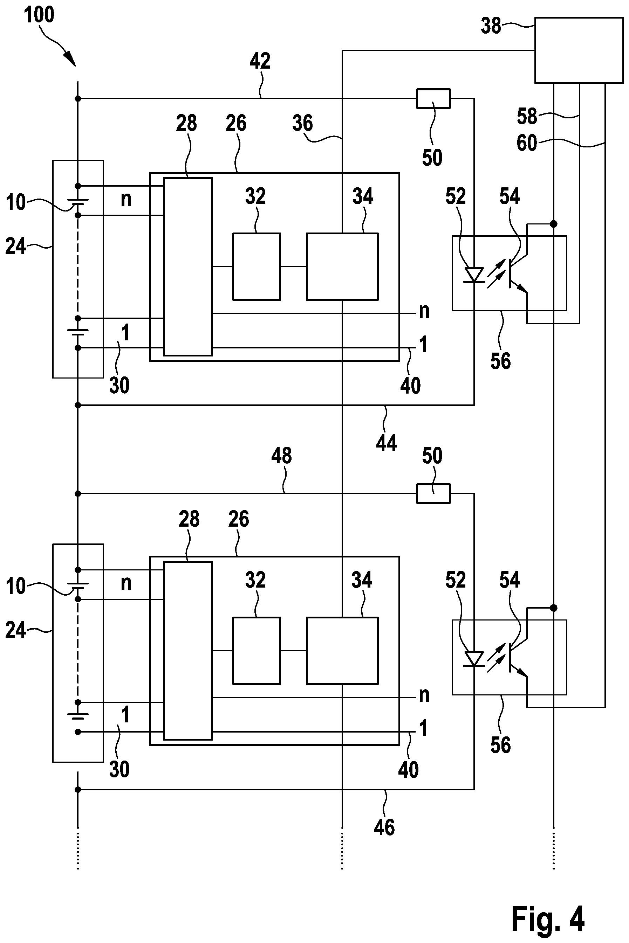

Figur 4 zeigt ein Batteriesystem 100 gemäß einer zweiten bevorzugten Ausführungsvariante der Erfindung. Hier werden für jedes Modul 24 jeweils zwei separate Modulmessleitungen 42 und 44 beziehungsweise 46 und 48 zur Verfügung gestellt. Ferner wird die Modulspannung über einen Vorwiderstand 50 in einen der Modulspannung entsprechenden Strom umgewandelt. Der Optokoppler 56, der durch eine Diode 52 und einen Transistor 54 ausgebildet ist, wirkt dann ausgangsseitig ebenfalls als Stromquelle, deren Strom proportional zur Modulspannung ist. Diese Ausführungsvariante hat den Vorteil, dass die ausgangsseitigen Modulmessleitungen 58 und 60 zum zentralen Steuergerät 38 keine hohen Spannungen mehr führen, was zu einer Erhöhung der Systemsicherheit beiträgt.

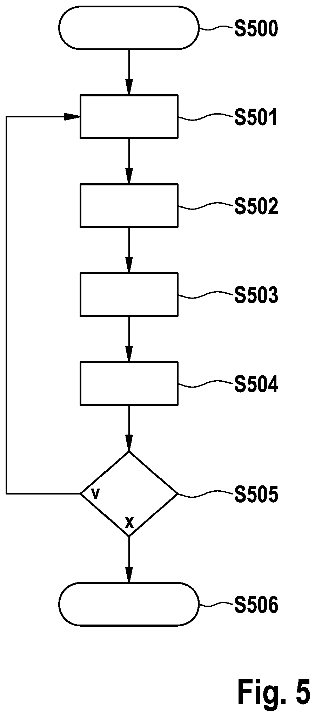

Figur 5 zeigt ein Blockschaltbild des Ablauf eines Notlaufbetriebs des erfindungsgemäßen Batteriesystems, welcher nach der Detektion eines Ausfalls (Verfahrensschritt S500) mindestens einer Zellspannungserfassungseinheit durchgeführt werden kann, um erfindungsgemäß ein sofortiges Abschalten des Batteriesystems zu vermeiden. Aus dem ohnehin permanent gemessenen Strom des Batteriesystems (Verfahrensschritt S501) können ausgehend vom zuletzt bekannten Zustand der Batteriezellen der Ladezustand und die daraus resultierenden Zellspannungen abgeschätzt werden (Verfahrensschritt S502). Eine solche Abschätzung kann durch mathematische Approximation unter Zuhilfenahme verschiedener aus dem Stand der Technik bekannter Algorithmen erfolgen. Es wird mit anderen Worten eine Wahrscheinlichkeit ermittelt, dass sich die Zellspannungen der einzelnen Batteriezellen (aufgrund der bekannten Stromstärke des Batteriesystems und den zuletzt bekannten Zellspannungen) in einem bestimmten Intervall befinden. Die Summe der jeweils zu einem Modul gehörenden Zellspannungen ergibt dann eine Abschätzung der Modulspannungen (Verfahrensschritt S503), welche mit den erfindungsgemäß separat gemessenen Modulspannungen verglichen werden (Verfahrensschritt S504). Solange die Differenz zwischen der Abschätzung und den Messwerten kleiner als eine vorgegebene Toleranz ist, kann der Betrieb des Batteriesystems aufrecht erhalten werden (Verfahrensschritt S505) und die Verfahrensschritte S501 bis S505 werden wiederholt. Andernfalls wird das Batteriesystem abgeschaltet (Verfahrensschritt S506).

## Patentansprüche

1. Batteriesystem (100) mit mindestens zwei Modulen (24), die jeweils eine Vielzahl von Batteriezellen (10) umfassen, wobei jedem Modul (24) eine Zellspannungserfassungseinheit (26) zugeordnet ist und jede der Zellspannungserfassungseinheiten (26) ausgebildet ist, die Spannung der einzelnen Batteriezellen (10) des zugeordneten Moduls (24) zu erfassen, und wobei die Zellspannungserfassungseinheiten (26) über einen gemeinsamen Kommunikationsbus (36) in Serie geschaltet und mit einem zentralen Steuergerät (38) verbunden sind, **dadurch gekennzeichnet, dass** jedes Modul (24) zusätzlich eine Modulspannungserfassungseinheit umfasst, die ausgebildet ist, die Spannung des zugeordneten Moduls (24) separat zu erfassen.

2. Batteriesystem nach Anspruch 1, wobei die Modulspannungserfassungseinheiten durch Modulmessleitungen (42, 44, 46) ausgebildet sind, wobei jeweils eine erste Modulmessleitung (44, 46) mit einem Pluspol des zugeordneten Moduls (24) und eine zweite Modulmessleitung (42, 44) mit einem Minuspol des zugeordneten Moduls (24) verbunden und zum zentralen Steuergerät (38) geführt sind.

3. Batteriesystem nach einem der vorhergehenden Ansprüche, wobei jede Modulspannungserfassungseinheit einen Optokoppler (56) aufweist, der eingangsseitig mit den Modulmessleitungen (42, 44, 46, 48) und ausgangsseitig mit dem zentralen Steuergerät (38) verbunden ist.

4. Batteriesystem nach Anspruch 3, wobei der Optokoppler (56) durch einen Vorwiderstand (50), eine Diode (52) und einen Transistor (54) ausgebildet ist.

5. Verfahren zur Bestimmung von Batteriemodulspannungen in einem Batteriesystem (100) nach einem der vorgenannten Ansprüche, wobei jede der Zellspannungserfassungseinheiten (26) die Spannungen der einzelnen Batteriezellen (10) bestimmt und wobei die bestimmten Spannungswerte über den gemeinsamen Kommunikationsbus (36) zum zentralen Steuergerät (38) übermittelt werden und wobei zusätzlich für jedes Modul (24) eine Modulspannung separat erfasst und dem zentralen Steuergerät (38) zugeführt wird, mit folgenden weiteren Verfahrensschritten:
- Detektion eines Ausfalls (S500) mindestens einer Zellspannungserfassungseinheit (26) durch Vergleich der vom gemeinsamen Kommunikationsbus (36) übermittelten Spannungswerte mit Referenzspannungswerten,
- Messen (S501) des aktuell vom Batteriesystem gelieferten Stroms,
- Bestimmen (S502) der Spannung der einzelnen Batteriezellen (10) anhand des gemessenen Stroms,
- Berechnung (S503) der Spannung der einzelnen Module (24) anhand der bestimmten Spannungswerte der einzelnen Batteriezellen (10),
- Bestimmen (S504) der Differenz der bestimmten Spannungswerte der Module (24) mit den separat erfassten Modulspannungen, und
- Vergleich (S505) des Betrag der bestimmten Differenz mit einem vorgegebenem Toleranzwert, und
- Abschalten (S506) des Batteriesystems, sofern der vorgegebene Toleranzwert überschritten wird.

6. Verfahren nach Anspruch 5, wobei die Verfahrensschritte: Messen (S501) des aktuell vom Batteriesystem gelieferten Stroms, Bestimmen (S502) der Spannung der einzelnen Batteriezellen (10) anhand des gemessenen Stroms, Berechnen (S503) der Spannung der einzelnen Module (24) anhand der bestimmten Spannungswerte der einzelnen Batteriezellen (10), Bestimmen (S504) der Differenz der bestimmten Spannungswerte der Module (24) mit den separat erfassten Modulspannungen, und Vergleich (S505) des Betrag der bestimmten Differenz mit einem vorgegebenem Toleranzwert jeweils kontinuierlich wiederholt werden.

7. Verfahren nach Anspruch 6, wobei die Wiederholrate größer als 0,1 Hz beträgt.

8. Verfahren nach Anspruch 7, wobei die Wiederholrate größer als 10 Hz beträgt.

9. Kraftfahrzeug mit einem Batteriesystem (100) nach einem der Ansprüche 1 bis 4, wobei das Batteriesystem (100) mit einem Antriebssystem des Kraftfahrzeugs verbunden ist.

## Claims

1. Battery system (100) having at least two modules (24) which each comprise a multiplicity of battery cells (10), wherein each module (24) has an associated cell voltage sensing unit (26), and each of the cell voltage sensing units (26) is designed to sense the voltage of the individual battery cells (10) of the associated module (24), and wherein the cell voltage sensing units (26) are connected in series by means of a common communication bus (36) and are connected to a central controller (38), **characterized in that** each module (24) additionally comprises a module voltage sensing unit which is designed to sense the voltage of the associated module (24) separately.

2. Battery system according to Claim 1, wherein the module voltage sensing units are formed by module measuring lines (42, 44, 46), wherein in each case a first module measuring line (44, 46) is connected to a positive pole of the associated module (24) and a second module measuring line (42, 44) is connected to a negative pole of the associated module (24) and said module measuring lines are routed to the central controller (38).

3. Battery system according to one of the preceding claims, wherein each module voltage sensing unit has an optocoupler (56) which has its input side connected to the module measuring lines (42, 44, 46, 48) and its output side connected to the central controller (38).

4. Battery system according to Claim 3, wherein the optocoupler (56) is formed by an input resistor (50), a diode (52) and a transistor (54).

5. Method for determining battery module voltages in a battery system (100) according to one of the preceding claims, wherein each of the cell voltage sensing units (26) determines the voltages of the individual battery cells (10) and wherein the determined voltage values are transmitted via the common communication bus (36) to the central controller (38) and wherein additionally a module voltage is sensed separately for each module (24) and supplied to the central controller (38), having the following further method steps:
- detection of failure (S500) of at least one cell voltage sensing unit (26) by comparing the voltage values transmitted by the common communication bus (36) with reference voltage values,
- measurement (S501) of the current delivered at present by the battery system,
- determination (S502) of the voltage of the individual battery cells (10) from the measured current,
- calculation (S503) of the voltage of the individual modules (24) from the determined voltage values of the individual battery cells (10),
- determination (S504) of the difference in the determined voltage values of the modules (24) with the separately sensed module voltages, and
- comparison (S505) of the absolute value of the determined difference with a prescribed tolerance value, and
- disconnection (S506) of the battery system if the prescribed tolerance value is exceeded.

6. Method according to Claim 5, wherein the method steps: measurement (S501) of the current delivered at present by the battery system, determination (S502) of the voltage of the individual battery cells (10) from the measured current, calculation (S503) of the voltage of the individual modules (24) from the determined voltage values of the individual battery cells (10), determination (S504) of the difference in the determined voltage values of the modules (24) with the separately sensed module voltages, and comparison (S505) of the absolute value of the determined difference with a prescribed tolerance value are each continuously repeated.

7. Method according to Claim 6, wherein the repetition rate is greater than 0.1 Hz.

8. Method according to Claim 7, wherein the repetition rate is greater than 10 Hz.

9. Motor vehicle having a battery system (100) according to one of Claims 1 to 4, wherein the battery system (100) is connected to a drive system of the motor vehicle.

## Revendications

1. Système de batterie (100) comprenant au moins deux modules (24) qui comportent respectivement une pluralité de cellules de batterie (10), une unité d'acquisition de tension de cellule (26) étant associée à chaque module (24) et chacune des unités d'acquisition de tension de cellule (26) étant configurée pour acquérir la tension des cellules de batterie (10) individuelles du module (24) associé, et les unités d'acquisition de tension de cellule (26) étant branchées en série par le biais d'un bus de communication (36) commun et étant reliées à un contrôleur central (38), **caractérisé en ce que** chaque module (24) comporte en plus une unité d'acquisition de tension de module qui est configurée pour acquérir séparément la tension du module (24) associé.

2. Système de batterie selon la revendication 1, les unités d'acquisition de tension de module étant formées par des lignes de mesure de module (42, 44, 46), une première ligne de mesure de module (44, 46) étant reliée respectivement à un pôle positif du module (24) associé et une deuxième ligne de mesure de module (42, 44) étant reliée respectivement à un pôle négatif du module (24) associé et étant acheminées au contrôleur central (38).

3. Système de batterie selon l'une des revendications précédentes, chaque unité d'acquisition de tension de module possédant un optocoupleur (56) qui est relié aux lignes de mesure de module (42, 44, 46, 48) du côté de l'entrée et au contrôleur central (38) du côté de la sortie.

4. Système de batterie selon la revendication 3, l'optocoupleur (56) étant formé par une résistance série (50), une diode (52) et un transistor (54).

5. Procédé de détermination des tensions de module de batterie dans un système de batterie (100) selon l'une des revendications précédentes, chacune des unités d'acquisition de tension de cellule (26) déterminant les tensions des cellules de batterie (10) individuelles et les valeurs de tension déterminées étant communiquées au contrôleur central (38) par le biais du bus de communication (36) commun et une tension de module étant en plus acquise séparément pour chaque module (24) et acheminée au contrôleur central (38), comprenant les étapes de procédé supplémentaires suivantes :
- détection d'une panne (S500) d'au moins une unité d'acquisition de tension de cellule (26) par comparaison des valeurs de tension communiquées par le bus de communication (36) commun avec des valeurs de tension de référence,
- mesure (S501) du courant actuellement délivré par le système de batterie,
- détermination (S502) de la tension des cellules de batterie (10) individuelles à l'aide du courant mesuré,
- calcul (S503) de la tension des modules (24) individuels à l'aide des valeurs de tension déterminées des cellules de batterie (10) individuelles,
- détermination (S504) de la différence des valeurs de tension déterminées des modules (24) avec les tensions de module acquises séparément et
- comparaison (S505) du montant de la différence déterminée avec une valeur de tolérance prédéfinie et
- mise hors circuit (S506) du système de batterie dans la mesure où la valeur de tolérance prédéfinie est dépassée.

6. Procédé selon la revendication 5, les étapes de procédé : mesure (S501) du courant actuellement délivré par le système de batterie, détermination (S502) de la tension des cellules de batterie (10) individuelles à l'aide du courant mesuré, calcul (S503) de la tension des modules (24) individuels à l'aide des valeurs de tension déterminées des cellules de batterie (10) individuelles, détermination (S504) de la différence des valeurs de tension déterminées des modules (24) avec les tensions de module acquises séparément et comparaison (S505) du montant de la différence déterminée avec une valeur de tolérance prédéfinie étant respectivement répétées continuellement.

7. Procédé selon la revendication 6, la fréquence de répétition étant supérieure à 0,1 Hz.

8. Procédé selon la revendication 7, la fréquence de répétition étant supérieure à 10 Hz.

9. Véhicule automobile comprenant un système de batterie (100) selon l'une des revendications 1 à 4, le système de batterie (100) étant relié à un système de propulsion du véhicule automobile.
